# FASCICULE DE BREVET EUROPEEN

(11) **EP 1 419 541 B1**
(45) Date de publication et mention de la délivrance du brevet: **31.08.2016**
(21) Numéro de dépôt: 02762547.4
(22) Date de dépôt: 17.07.2002
(51) Int. Cl.: H01L 27/32

(54) **PANNEAU DE VISUALISATION D'IMAGES FORME D'UNE MATRICE DE CELLULES ELECTROLUMINESCENTES A EFFET MEMOIRE**
BILDANZEIGEVORRICHTUNGSPANEEL HERGESTELLT AUS EINER MATRIX VON ELEKTROLUMINESZENTEN ZELLEN MIT SPEICHEREFFEKT
IMAGE DISPLAY PANEL CONSISTING OF A MATRIX OF MEMORY-EFFECT ELECTROLUMINESCENT CELLS

(30) Priorité: 27.07.2001 FR 0110289
(43) Date de publication de la demande: 19.05.2004
(73) Titulaire: Thomson Licensing, 92130 Issy-les-Moulineaux (FR)
(72) Inventeur: DAGOIS, Jean-Paul, F-35510 Cesson Sévigné (FR); HAAS, Gunther, F-35760 Saint Grégoire (FR)
(74) Mandataire: Browaeys, Jean-Philippe
(86) Numéro de dépôt international: PCT/FR2002/002548
(87) Numéro de publication internationale: WO 2003/012869

(56) Documents cités:
- US-A- 3 070 701
- US-A- 5 053 679
- US-A- 5 055 739
- US-B1- 6 188 175

## Description

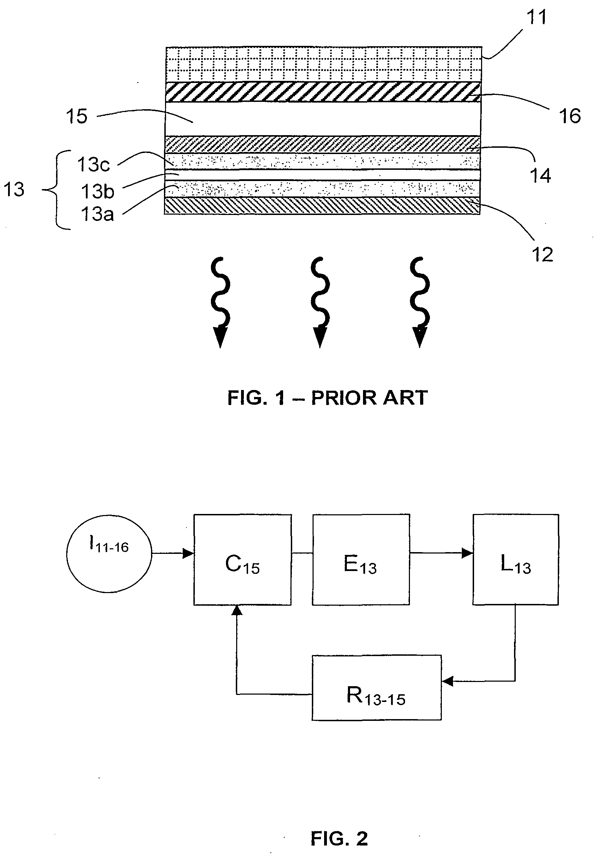

L'invention concerne un panneau de visualisation d'images formé d'une matrice de cellules électroluminescentes à effet mémoire, comprenant, en référence à la figure 1 :
- une couche organique électroluminescente 13 susceptible d'émettre de la lumière vers l'avant dudit panneau (flèches d'émission de lumière sur la figure),
- à l'avant de cette couche, une couche avant transparente d'électrodes 12,
- à l'arrière de cette couche, une couche photoconductrice 15, elle-même intercalée entre une couche arrière opaque d'électrodes 16 et une couche intermédiaire d'électrodes 14 au contact de la couche électroluminescente.

La couche photoconductrice 15 est destinée à apporter aux cellules du panneau un effet mémoire qui sera décrit ultérieurement.

Les panneaux de ce type comportent également un substrat 11, à l'arrière ou à l'avant du panneau, pour supporter l'ensemble des couches précédemment décrites ; il s'agit en général d'une plaque de verre ou de matériau polymère.

Les électrodes de ce panneau doivent être adaptées pour pouvoir commander et maintenir l'émission des cellules du panneau, indépendamment les unes des autres ; à cet effet, chaque électrode de la couche avant 12 dessert une ligne Y de cellules et chaque électrode de la couche arrière dessert une colonne X de cellules ; les électrodes peuvent également avoir la configuration inverse : électrodes de couche avant en colonnes et électrodes de couche arrière en ligne ; les cellules du panneau sont alors situées aux intersections des électrodes lignes Y et des électrodes colonnes X, et sont ainsi disposées en matrice.

L'invention a pour but une disposition avantageuse des électrodes de la couche intermédiaire.

Pour visualiser sur un tel panneau des images partitionnées en une matrice de points lumineux, on alimente les électrodes des différentes couches de manière à faire circuler un courant électrique au travers des cellules du panneau correspondant aux points lumineux de ladite image ; le courant électrique qui circule entre une électrode X et une électrode Y pour alimenter une cellule positionnée à l'intersection de ces électrodes, traverse la couche électroluminescente 13 située à cette intersection ; la cellule ainsi excitée par ce courant émet alors de la lumière vers la face avant du panneau ; l'émission de l'ensemble des cellules excitées du panneau forme l'image à visualiser.

Les documents US 4035774 - IBM , US 4808880 - CENT, US 6188175 B1 - CDT décrivent des panneaux de ce type.

La couche organique électroluminescente 13, se décompose en général en trois sous-couches : une sous-couche centrale 13b électroluminescente intercalée entre une sous-couche 13a de transport de trous et une sous-couche 13c de transport d'électrons.

Les électrodes de la couche avant d'électrodes 12, au contact de la sous-couche 13a de transport de trous, servent alors d'anodes ; cette couche d'électrodes 12 doit être transparente, au moins partiellement, pour laisser passer vers l'avant du panneau la lumière émise par la couche électroluminescente 13 ; les électrodes de cette couche sont généralement elles-mêmes transparentes et réalisées en oxyde mixte d'étain et d'indium (« ITO »), ou en polymère conducteur comme du polyéthylènedioxythiophène (« PDOT »).

Les électrodes de la couche intermédiaire d'électrodes 14, au contact de la sous-couche 13c de transport d'électrons, servent alors de cathodes ; cette couche doit être suffisamment transparente pour assurer un couplage optique entre la sous-couche centrale 13b électroluminescente et la couche photoconductrice 15 ; comme décrit ci-après, ce couplage optique est nécessaire au fonctionnement du panneau ; le document US 6188175 enseigne que cette couche peut être en matériau conducteur transparent et que, si elle est en matériau conducteur opaque, elle doit être alors dotée et percée de motifs adaptés pour laisser passer le maximum de lumière (colonne 5, lignes 60-64).

Les documents cités ci-dessus divulguent également des configurations où les positions de la sous-couche 13a d'injection de trous et de la sous-couche 13c d'injection d'électrons sont inversées par rapport à la sous-couche centrale 13b électroluminescente ; la sous-couche d'injection de trous 13a est alors en contact avec les électrodes de la couche intermédiaire 14, qui deviennent des anodes et la sous-couche d'injection d'électrons 13c est alors en contact avec les électrodes de la couche avant 12, qui servent alors de cathodes.

Selon une autre variante, la couche avant d'électrodes 12 peut elle-même comporter plusieurs sous-couches, dont une sous-couche d'interface avec la couche organique électroluminescente 13 destinée à améliorer l'injection de trous (cas anode) ou d'électrons (cas cathode).

La couche photoconductrice 15 peut être par exemple en silicium amorphe, ou en sulfure de cadmium.

Dans les panneaux de visualisation de ce type, le rôle de la couche photoconductrice 15 est d'apporter un effet « mémoire » aux cellules du panneau ; chaque cellule du panneau englobe une zone de couche électroluminescente 13 et, au regard de celle-ci, une zone de couche photoconductrice 15 qui joue le rôle d'interrupteur d'alimentation de la cellule ; dès qu'une zone de couche électroluminescente 13 est excitée par application d'un potentiel adapté à ses bornes, la zone correspondante de la couche photoconductrice 15 reçoit de la lumière émise par la couche électroluminescente 13 au travers des électrodes de la couche intermédiaire 14, et devient conductrice.

Les différentes électrodes du panneau doivent être alimentées et pilotées de manière à ce que, tant qu'une zone de la couche photoconductrice 15 est conductrice, un courant électrique traverse la zone correspondante de la couche électroluminescente 13 de sorte que cette zone continue d'émettre de la lumière et que la zone correspondante de la couche photoconductrice 15 reste conductrice ; ainsi, lorsque l'interrupteur, qui correspond à une zone de couche photoconductrice 15, passe à l'état fermé , cet interrupteur reste à l'état fermé et la cellule continue d'être excitée ; cet interrupteur doit donc fonctionner comme une bascule de manière à conférer un « effet mémoire » aux cellules du panneau.

Cet effet mémoire correspond donc à un fonctionnement en boucle de chaque cellule du panneau, tel que représenté à la figure 2 : tant qu'une cellule électroluminescente E₁₃ émet de la lumière L₁₃ qui agit, via un couplage R₁₃₋₁₅, sur la zone correspondante C₁₅ de la couche photoconductrice 15, l'interrupteur à bascule formé par cette zone C₁₅ est fermé, et tant que cet interrupteur C₁₅ est fermé, la cellule électroluminescente E₁₃ émet de la lumière L₁₃.

L'invention a pour but de proposer une structure adaptée des différentes couches d'électrodes, notamment de la couche intermédiaire d'électrodes, et optionnellement un procédé de pilotage de ces électrodes, qui sont simples et économiques à fabriquer ou à mettre en oeuvre, et qui assurent un fonctionnement à effet mémoire de toutes les cellules du panneau.

Le fonctionnement en boucle de chaque cellule du panneau repose également sur un couplage optique R₁₃₋₁₅ entre la couche électroluminescente 13 et la couche photoconductrice 15 ; ce couplage pose de graves problèmes car il dépend de la structure du panneau et des matériaux électroluminescents et photoconducteurs : en effet, la résistance de la zone photoconductrice d'une cellule dépend de la nature du matériau photoconducteur, de la surface de cette zone, de son épaisseur au sein de la couche photoconductrice 13 ; de plus, la surface de cette zone susceptible de passer à l'état conducteur dépend, entre autres, de l'intensité d'émission de la cellule électroluminescente, de la sensibilité du matériau photoconducteur, et de son niveau d'absorption de la lumière émise par la cellule ; l'intensité d'émission de la cellule électroluminescente dépend elle-même de l'épaisseur de la couche électroluminescente et du matériau électroluminescent.

En outre, dans les panneaux de visualisation d'image en couleur, qui comprennent des cellules émettant différentes couleurs, le niveau d'éclairement requis pour que la zone photoconductrice d'une cellule passe à l'état conducteur va varier selon la couleur d'émission de cette cellule, parce que le matériau photoconducteur présente en général une sensibilité différente selon les couleurs ; dans ce cas, le couplage optique entre la couche électroluminescente 13 et la couche photoconductrice 15 pose encore des problèmes supplémentaires.

Un but de l'invention est d'offrir une solution souple et économique aux problèmes de couplage optique entre la couche électroluminescente 13 et la couche photoconductrice 15 des panneaux de visualisation du type précité comme décrit dans les revendications 1-5 et le procédé des revendications 6-8.

Le document US3070701 décrit un panneau de visualisation d'images formé d'une matrice de cellules électroluminescentes à effet mémoire, susceptibles d'émettre de la lumière vers l'avant dudit panneau, comprenant :
- une couche électroluminescente (réf. 14),
- à l'avant de cette couche, une couche avant transparente d'électrodes (réf. 12),
- à l'arrière de cette couche, une couche photoconductrice pour obtenir ledit effet mémoire (réf. 22), elle-même intercalée entre une couche arrière opaque d'électrodes (réf. 24) et une couche transparente ou semi-transparente intermédiaire d'électrodes intermédiaires au contact de la couche électroluminescente (réf. 16), dans lequel chaque cellule est dotée d'une électrode intermédiaire et dans lequel les électrodes intermédiaires des différentes cellules sont isolées électriquement les unes des autres (colonne 3, lignes 24-25).

Dans ce document, la couche électroluminescente n'est pas organique.

Toutes ces couches sont intégrées au sein d'un même panneau sur un même et unique substrat.

Les couches d'électrodes avant et arrières sont généralement discontinues de manière à former un réseau de conducteurs pilotables séparément.

Chaque cellule du panneau comprend alors, entre une électrode de la couche avant et une électrode de la couche arrière, une zone de couche électroluminescente, une électrode intermédiaire et une zone de couche photoconductrice.

Chaque cellule du panneau est alors alimentée entre une électrode d'adressage et de maintien de la couche avant ou arrière et une électrode dite de donnée de l'autre couche, arrière ou avant.

Un tel panneau offre un effet mémoire qui permet de le piloter d'une manière très simple est économique ; ainsi, de préférence, ce panneau comprend des moyens d'alimentation et de pilotage adaptés :
- pour appliquer successivement à chaque électrode d'adressage et de maintien, un signal dit de déclenchement d'écriture Vₐ lors d'une phase d'adressage et pour appliquer pendant ce temps aux autres électrodes d'adressage et de maintien un signal dit de maintien V_{S},
- et, pendant l'application d'un signal d'écriture Vₐ à ladite électrode d'adressage et de maintien, pour appliquer simultanément aux électrodes de donnée un signal de donnée de valeur soit V_{Off}, soit V_{On} selon que l'on souhaite respectivement ne pas activer ou activer la cellule située au croisement de l'électrode de donnée considérée avec ladite électrode d'adressage et de maintien lors de la phase subséquente de maintien des cellules alimentée par ladite électrode d'adressage et de maintien.

Si V_{T} est la tension aux bornes d'une cellule du panneau au delà de laquelle une cellule éteinte à l'état non activé « OFF » passe à l'état activé « ON », si V_{D} est la tension de déclenchement de l'émission de la portion de ladite couche électroluminescente correspondant à une cellule, de préférence les moyens d'alimentation et de pilotage sont adaptés pour que :
- Vₐ-Vₒₙ ≥ V_{T} et Vₐ-V_{off} < V_{T}
- V_{S}-Vₒₙ < V_{T} et Vₛ-V_{off} > V_{D}

On obtient ainsi l'effet mémoire recherché qui permet de simplifier considérablement la commande et le pilotage du panneau.

Selon une variante de l'invention, les moyens d'alimentation et de pilotage sont adaptés pour appliquer simultanément, lors de chaque phase d'adressage d'une électrode d'adressage et de maintien, un signal V_{C} dit de compensation aux différentes électrodes de donnée, où V_{C}= V_{Off} pour les électrodes de données recevant un signal de donnée Vₒₙ lors de ladite phase d'adressage, où V_{C}= Vₒₙ pour les électrodes de données recevant un signal de donnée V_{off} lors de ladite phase d'adressage, la durée d'application dudit signal de compensation V_{C} étant approximativement égale à la durée d'application du signal de donnée Vₒₙ ou V_{off}.

Le signal de compensation est de préférence appliqué immédiatement après le signal de déclenchement d'écriture.

Grâce à ce signal de compensation, à chaque phase d'adressage d'une électrode d'adressage et de maintien, la moyenne des signaux envoyés aux électrodes de donnée est toujours identique quelle que soit le nombre de cellules à activer ou à ne pas activer qui sont alimentées par ladite électrode d'adressage et de maintien, c'est à dire quelle que soit le contenu vidéo affecté à ladite électrode ; de ce fait, les autres électrodes, qui ne sont pas en phase d'adressage mais de maintien pendant ce temps, ne sont pas affectées par le contenu vidéo de l'électrode en cours d'adressage, ce qui permet d'assurer avantageusement une répartition très homogène de l'énergie électrique fournie par les moyens d'alimentation et de pilotage à ces électrodes en phase de maintien ; grâce à cette opération sélective de compensation accolée à chaque opération d'écriture, on améliore sensiblement la qualité de l'image affichée par le panneau.

Lors de chaque phase d'adressage d'une électrode d'adressage et de maintien, avant le signal de déclenchement d'écriture, on applique généralement des signaux d'effacement V_{E-Y} et V_{E-X} respectivement à l'électrode d'adressage et de maintien et aux électrodes de donnée ; il convient de choisir V_{E-Y} -V_{E-X} < V_{D} de manière à éteindre toutes les cellules qui sont alimentées par ladite électrode d'adressage et de maintien ; généralement, pour simplifier les moyens d'alimentation et de pilotage, on choisit V_{E-Y} = V_{E-X} = Vₒₙ.

Dans le but d'offrir une solution souple et économique aux problèmes de couplage optique précités, le panneau selon l'invention comprend une couche opaque comprise entre la couche électroluminescente et la couche photoconductrice qui comprend elle-même, au niveau de chaque cellule du panneau, un groupe d'au moins une ouverture de couplage optique traversant cette couche opaque ; de préférence, chaque groupe est positionné approximativement au centre d'une cellule ; selon une variante, la couche opaque fait partie de la couche intermédiaire d'électrodes.

On entend par couche opaque, une couche qui ne laisse pas passer la lumière visible ; cette couche peut être absorbante (noire) ou réfléchissante (métal).

Ainsi, si la couche opaque est en matériau isolant, c'est par les trous dans cette couche que non seulement la lumière mais aussi le courant électrique passeront de la couche électroluminescente à la couche photoconductrice au travers des électrodes intermédiaires qui doivent donc être transparentes ou semi-transparentes ; excepté ces trous, cette couche opaque peut être continue puisqu'elle est isolante et ne risque pas de court-circuiter les électrodes intermédiaires avec lesquelles elle est en contact.

Si la couche opaque est en matériau conducteur, elle devient partie intégrante des électrodes intermédiaires ; elle ne peut donc plus être continue puisque les électrodes intermédiaires sont, selon l'invention, isolées électriquement les unes des autres.

Dans le but d'offrir une autre solution souple et économique aux problèmes de couplage optique précités, la couche intermédiaire d'électrodes du panneau est semi-transparente et présente une densité optique adaptée au couplage optique nécessaire entre ladite couche électroluminescente et ladite couche photoconductrice pour obtenir ledit effet mémoire.

Le nombre et la surface des ouvertures dans la couche opaque ou la densité optique de la couche intermédiaire semi-transparente sont des moyens simples et économiques pour adapter, au niveau de chaque cellule, le couplage optique entre la couche électroluminescente et la couche photoconductrice et optimiser ainsi le fonctionnement du panneau : en effet, ce couplage optique peut être réglé et adapté avantageusement selon les panneaux et selon les cellules d'un même panneau en choisissant le nombre d'ouvertures par groupe et la surface de ces ouvertures ; en résumé, ces ouvertures permettent avantageusement d'adapter localement l'excitation de la couche photoconductrice.

Chaque groupe d'ouvertures d'une cellule ou chaque électrode intermédiaire semi-transparente joue le rôle de moyen d'adaptation du niveau d'éclairement de la zone photoconductrice au niveau requis pour que cette zone passe à l'état conducteur.

Lorsque le panneau comprend au moins deux groupes de cellules électroluminescentes susceptibles d'émettre de la lumière de couleur différente, selon le mode d'adaptation du couplage optique selon l'invention :
- soit la densité d'ouvertures et/ou la somme des surfaces des ouvertures d'un groupe d'ouvertures diffèrent selon les groupes de cellules de couleur différente,
- soit la densité optique de ladite couche intermédiaire diffère selon les groupes de cellules de couleur différente.

Grâce à l'invention, en adaptant à la couleur d'émission d'une cellule l'ouverture globale de cette cellule, c'est à dire la somme des surfaces des ouvertures de couplage optique de cette cellule et/ou la densité de ces ouvertures, il est facile d'obtenir une conductivité identique à l'état excité pour toutes les zones de couche photoconductrice au regard de toutes les cellules du panneau, quelle que soit leur couleur d'émission, et d'améliorer ainsi le fonctionnement du panneau.

De préférence, en regard de chaque ouverture de chaque groupe d'ouvertures de couplage optique, le panneau comporte un élément opaque de masquage positionné à l'avant de la couche électroluminescente.

Grâce à ces éléments opaques, on masque chaque ouverture de couplage optique dans la couche opaque intermédiaire vis à vis de l'éclairage ambiant externe du panneau et on limite les risques d'entrée de lumière ambiante dans la couche photoconductrice ; on limite donc les risques de dysfonctionnement du panneau sous lumière ambiante de forte intensité ; en effet, les ouvertures de couplage optique de chaque cellule, qui sont destinées au transfert de lumière vers la couche photoconductrice à condition que cette lumière provienne de la couche électroluminescente, sont ainsi masquées vis à vis d'une source de lumière externe au panneau.

De préférence, les deux interfaces de la couche photoconductrice sont réfléchissantes, sauf, de préférence, dans les zones inter-cellules qui correspondent aux zones situées entre les électrodes intermédiaires.

Ces interfaces réfléchissantes jouent alors le rôle de guide de lumière pour la lumière parvenant dans la couche photoconductrice au travers des ouvertures selon l'invention ; cette lumière peut alors se propager de manière à illuminer et à exciter une plus grande surface de couche photoconductrice que dans l'art antérieur, ce qui diminue avantageusement la résistance électrique de cette couche à l'état excité et limite les pertes électriques ; cet effet de guide de lumière est particulière avantageux dans le cas de l'utilisation d'un matériau photoconducteur, notamment organique, présentant un indice comparable à celui du matériau organique électroluminescent.

L'invention sera mieux comprise à la lecture de la description qui va suivre, donnée à titre d'exemple non limitatif, et en référence aux figures
- la figure 1, déjà décrite, est une vue schématique en coupe d'une cellule d'un panneau de visualisation électroluminescent à mémoire, doté d'une couche photoconductrice selon l'art antérieur,
- la figure 2 décrit le fonctionnement en boucle des cellules de ce type de panneau ;
- les figures 3 et 4 sont des vues schématiques en coupe d'une cellule d'un panneau de visualisation selon l'invention, selon un premier mode de réalisation où les électrodes de la couche intermédiaire sont transparentes et partiellement masquées par une couche opaque percée de trous ;
- les figures 5 et 6 sont des vues schématiques en coupe d'une cellule d'un panneau de visualisation selon l'invention, selon un deuxième mode de réalisation où les électrodes de la couche intermédiaire sont composites multi-couches et semi-transparentes ;
- la figure 7 représente, selon un troisième mode de réalisation de l'invention, une vue de dessus d'une couche intermédiaire formée ici d'électrodes opaques percées de trous de passage de la lumière au niveau de chaque cellule ;
- la figure 8 représente, selon un quatrième mode de réalisation de l'invention, une vue de dessus d'une couche intermédiaire identique à celle de la figure 7 à la différence près que l'ouverture des trous de chaque cellule dépend de la couleur émise par la cellule ;
- la figure 9 est une vue schématique en coupe selon l'axe 9-9 d'une portion de panneau doté de la couche intermédiaire de la figure 7 selon le troisième mode de réalisation ;
- la figure 10 est une vue schématique en coupe selon l'axe 10-10 d'une portion de panneau doté de la couche intermédiaire de la figure 8 selon le quatrième mode de réalisation ;
- la figure 11 est une vue schématique identique à celle de la figure 9 à la différence près que, selon un cinquième mode de réalisation, le panneau est ici doté en face avant d'éléments opaques de masquage disposés face à chaque trou d'ouverture de la couche intermédiaire ;
- les figures 12 et 13 sont des coupes du panneau respectivement selon la direction des électrodes lignes et selon la direction des électrodes colonnes, destinées à illustrer un procédé de fabrication du panneau selon l'invention,
- la figure 14 représente le schéma électrique équivalent d'un groupe de cellules du panneau selon l'invention,
- la figure 15 représente les différences de potentiel appliquées aux électrodes, selon la méthode de commande de la figure 16,
- la figure 16 représente des chronogrammes de tension appliquées à des électrodes du panneau selon l'invention, pour la commande de ce panneau.

Les figures représentant des chronogrammes ne prennent pas en compte d'échelle de valeurs afin de mieux faire apparaître certains détails qui n'apparaîtraient pas clairement si les proportions avaient été respectées.

Afin de simplifier la description et de faire apparaître les différences et avantages que présente l'invention par rapport à l'état antérieur de la technique, on utilise des références identiques pour les éléments qui assurent les mêmes fonctions.

Différents modes de réalisation du panneau selon l'invention seront décrits ultérieurement ; un point commun à tous les panneaux selon l'invention est que chaque cellule est dotée d'une électrode intermédiaire et que les électrodes intermédiaires des différentes cellules sont isolées électriquement les unes des autres ; chaque cellule comprend alors, entre une borne reliée à une électrode de la couche avant et une autre borne reliée à une électrode de la couche arrière, une zone de couche organique électroluminescente, une électrode intermédiaire et une zone de couche photoconductrice ; ainsi, toutes les électrodes intermédiaires sont flottantes.

L'effet mémoire que l'on cherche à obtenir pour chaque cellule de ce panneau est destiné à pouvoir utiliser un procédé dans lequel, successivement pour chaque ligne de cellules du panneau, on passe par une phase d'adressage « adress » destinée à allumer les cellules à allumer dans cette ligne, puis par une phase de maintien « sustain » destinée à maintenir les cellules de cette ligne dans l'état où la phase précédente d'adressage les a mises ou laissées ; pendant que les cellules d'une ligne sont en phase d'adressage, toutes les cellules des autres lignes du panneau sont en phase de maintien.

Selon un mode de pilotage classique de panneaux matriciels, la durée des phases de maintien permet de moduler la luminance des cellules du panneau et, notamment, de générer les niveaux de gris nécessaires à la visualisation d'une image.

La mise en oeuvre d'un procédé de pilotage exploitant l'effet mémoire des cellules du panneau passe alors par :
- lors des phases d'adressage, l'application, uniquement aux bornes des cellules à allumer, d'une tension d'allumage Vₐ ;
- lors des phases de maintien, l'application aux bornes de toutes les cellules d'une tension de maintien qui peut fluctuer mais qui doit rester suffisamment élevée pour que les cellules préalablement allumées restent allumées, et suffisamment faible pour ne pas risquer d'allumer les cellules préalablement non allumées.

La phase d'adressage est donc une phase sélective ; la phase de maintien n'est au contraire pas sélective, ce qui permet d'appliquer la même tension à toutes les cellules et simplifie considérablement la commande du panneau.

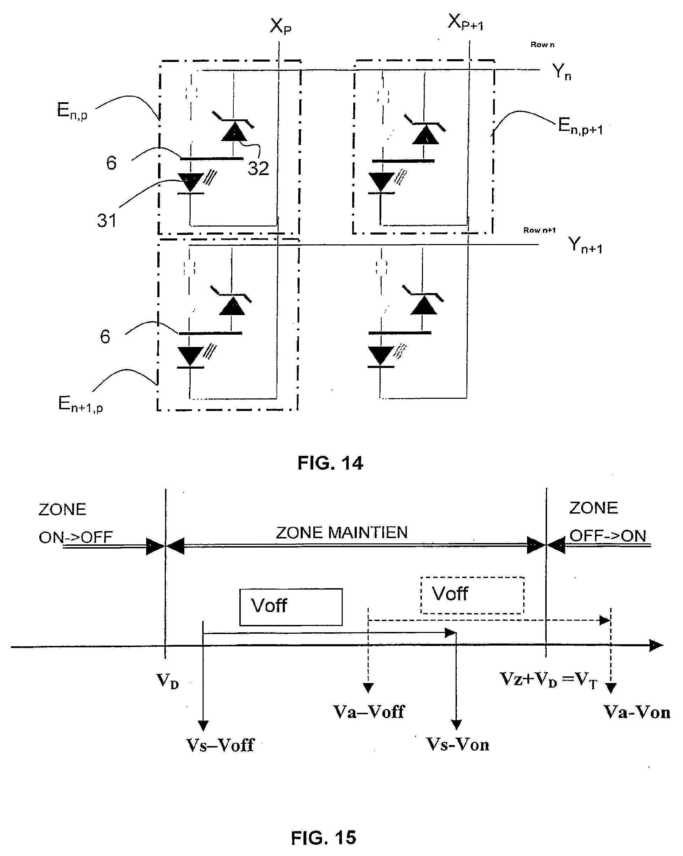

La figure 14 représente le schéma équivalent électrique d'un ensemble de cellules E_{n,p}, E_{n+1,p}, E_{n,p+1} ... du panneau selon l'invention, qui sont alimentées par des lignes d'électrodes Yₙ, Yₙ₊₁ de la couche avant 12 et des colonnes d'électrodes Xₚ, Xₚ₊₁ de la couche arrière 16.

Chaque cellule du panneau peut être électriquement représentée comme une diode électroluminescente 31 en série avec une diode Zener 32 avec une électrode intermédiaire 6 comme point commun :
- la zone de couche électroluminescente 13 correspondant à cette cellule fonctionne comme une diode électroluminescente,
- la zone correspondante de couche photoconductrice 15 fonctionne comme une diode Zener, parce qu'elle est optiquement couplée avec la zone de couche électroluminescente ; l'effet Zener représenté est obtenu en combinant le seuil d'émission lumineux de la diode électroluminescente et la caractéristique photoélectrique du matériaux photoconducteur.
- la zone correspondante de couche intermédiaire 14 correspond à l'électrode flottante 6.

On va maintenant décrire plus précisément l'effet mémoire qu'on cherche à obtenir lorsqu'on applique un procédé de commande du type précité à un panneau électroluminescent où, selon l'invention, les électrodes intermédiaires des différentes cellules sont isolées électriquement les unes des autres et sont flottantes.

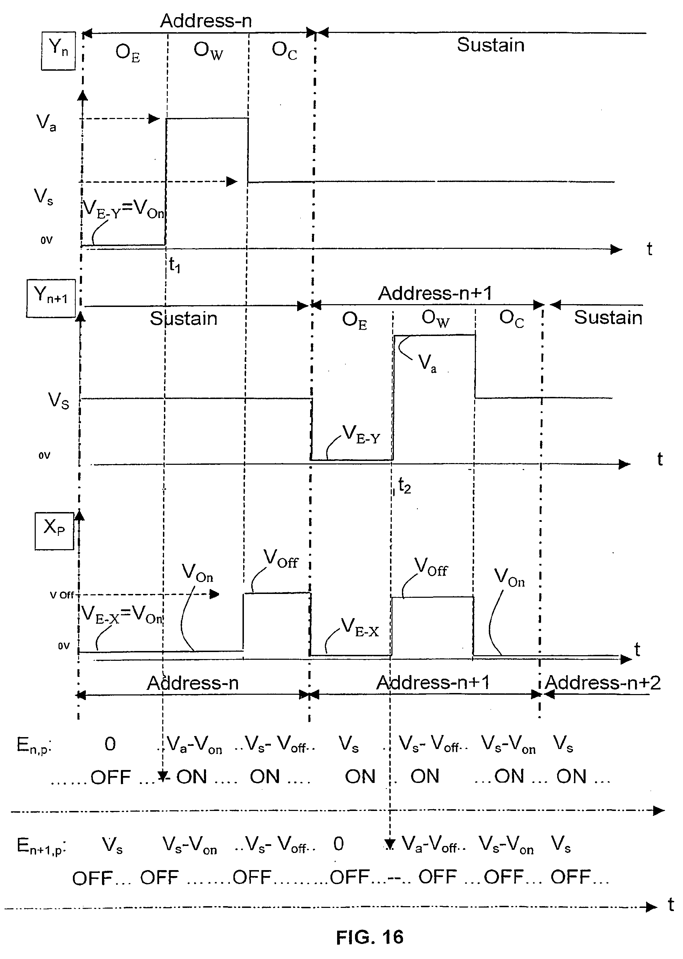

La figure 16 illustre, selon ce mode de commande classique :
- pour une cellule E_{n,p}, une phase complète d'adressage « adress-n », avec allumage de celle cellule qui reste allumée pour t>t₁,
- pour une cellule de la ligne suivante E_{n+1,p} « adress-n+1 », une phase complète d'adressage, sans allumage de celle cellule qui reste éteinte pour t>t₂.

Les trois chronogrammes Yₙ, Yₙ₊₁, Xₚ indiquent les tensions appliquées aux électrodes lignes Yₙ, Yₙ₊₁ et à l'électrode colonne Xₚ pour obtenir ces séquences.

Selon l'invention et en référence à la figure 16, chaque phase d'adressage comprend une opération d'effacement O_{E}, une opération d'écriture O_{W}, et une opération dite de compensation O_{C}.

Le bas de la figure 16 indique les valeurs de potentiels aux bornes des cellules E_{n,p}, E_{n+1,p} et l'état allumé (« ON ») ou éteint (« OFF ») de ces cellules.

Le panneau selon l'invention est doté de moyens d'alimentation et de pilotage adaptés pour pouvoir fournir aux électrodes les signaux suivants :
- pour les électrodes lignes, soit une tension Vₒₙ, généralement nulle ou proche de zéro, soit une tension dite de déclenchement d'écriture Vₐ, soit une tension de maintien V_{S} ;
- pour les électrodes colonnes, soit la tension Vₒₙ dite de donnée d'activation, soit la tension V_{off} dite de donnée de non-activation.

La réalisation de tels moyens d'alimentation est à la portée de l'homme du métier et ne sera pas décrite ici en détail.

Pour obtenir les états ON ou OFF indiqué au bas de la figure 16, il faut donc que, en appliquant aux bornes d'une cellule telle que représentée à la figure 14 :
- une différence de potentiel (Vₐ-Vₒₙ) à une cellule à l'état OFF, cette cellule bascule à l'état ON ;
- une différence de potentiel (Vₛ-Vₒₙ) ou (Vₛ-V_{off}) à une cellule à l'état ON, cette cellule reste à l'état ON ;
- une différence de potentiel (Vₐ-V_{off}) ou (Vₛ-Vₒₙ) à une cellule à l'état OFF, cette cellule reste à l'état OFF ;

Soit V_{D} la tension de déclenchement de l'émission de la diode électroluminescente 31 et V_{z} la tension critique de la diode Zener 32 ; la figure 15 reprend ces différentes valeurs de potentiel en les situant par rapport :
- à la tension seuil V_{D} aux bornes de la diode électroluminescente 31 de la cellule (figure 14), en deçà laquelle cette diode s'éteint et au delà de laquelle elle s'allume ;
- à la tension seuil V_{D}+V_{Z} aux bornes d'une cellule au delà de laquelle une cellule éteinte à l'état OFF s'allume et passe à l'état ON.

Pour obtenir l'effet mémoire recherché à l'aide du panneau selon l'invention, la valeur de la tension V_{off} susceptible d'être appliquée aux électrodes colonnes comme Xₚ doit être choisie de manière à ce que la tension Vₐ-V_{off} appliquée aux bornes d'une cellule ne soit pas suffisante pour l'allumer, donc que Vₐ-V_{off} < V_{D}+V_{Z} et à ce que la tension Vₛ-V_{off} n'affecte pas l'état allumé ou éteint de la cellule, donc que V_{D} < Vₛ-V_{off}.

La tension V_{D}+V_{Z} correspond à une tension V_{T} aux bornes d'une cellule du panneau au delà de laquelle une cellule éteinte à l'état OFF s'allume et passe à l'état ON.

Lors de chaque opération d'écriture O_{W} d'une ligne Yₙ du panneau, la moyenne des signaux envoyés aux différentes colonnes X1, ..., Xp, ... dépend du nombre de cellules à activer ou à ne pas activer sur cette ligne Yₙ ; pendant cette opération d'écriture, toutes les autres lignes du panneau sont en phase de maintien et les cellules activées de ces lignes sont alimentées par la différence de potentiel entre le potentiel Vₛ appliqué à ces lignes et le potentiel Vₒₙ ou V_{off} appliqué aux électrodes colonne Xₚ ; on voit donc que la différence de potentiel aux bornes des cellules en phase de maintien varie selon les colonnes auxquelles elles appartiennent : Vₛ-Vₒₙ, ou Vₛ-V_{off} ; de ce fait, la puissance lumineuse émise par les cellules des autres lignes va varier selon que, dans la colonne auxquelles elles appartiennent, la cellule de la ligne Yₙ est à activer ou non.

L'opération de compensation O_{c} qui suit chaque opération d'écriture permet d'éviter cet inconvénient: comme illustré sur la figure 16, cette opération consiste à appliquer un signal V_{Off} aux colonnes X recevant un signal de donnée Vₒₙ lors de l'opération préalable d'écriture O_{W}, ou un signal Vₒₙ aux colonnes X recevant un signal de donnée V_{off} lors de l'opération préalable d'écriture O_{W} ; si, en outre, la durée d'application de ce signal de compensation est approximativement égale à la durée d'application du signal préalable de donnée Vₒₙ ou V_{off}, on peut dire qu'en intégrant la durée d'une opération d'écriture et celle d'une opération de compensation, toutes les colonnes reçoivent en moyenne le même potentiel quelle que soit la ligne adressée et quelle que soit nombre de cellules à activer ou à ne pas activer sur ces lignes, ce qui permet d'éviter l'inconvénient précité ; ces opérations de compensation qui sont intégrées, selon l'invention, aux phases d'adressage permettent d'assurer l'homogénéité de l'émission des pixels non adressés du panneau.

Avant chaque opération d'écriture O_{W} d'une ligne Yₙ du panneau, on procède généralement à une opération d'effacement O_{E} qui consiste à appliquer des signaux d'effacement V_{E-Y} et V_{E-X} respectivement à l'électrode d'adressage et de maintien et aux électrodes de donnée ; il convient de choisir V_{E-Y} -V_{E-X} < V_{D} de manière à éteindre toutes les cellules qui sont alimentées par ladite électrode d'adressage et de maintien ; généralement, comme illustré sur la figure 16, pour simplifier les moyens d'alimentation et de pilotage, on choisit V_{E-Y} = V_{E-X} = Vₒₙ.

On vient de voir donc comment le panneau électroluminescent selon l'invention peut être avantageusement piloté, d'une manière très simple grâce à l'effet mémoire et, de préférence en ajoutant une opération de compensation dans les phase d'adressage.

On va maintenant décrire différents modes de réalisation du panneau selon l'invention basés sur des modes de couplage optique différents entre la couche électroluminescente et la couche photoluminescente.

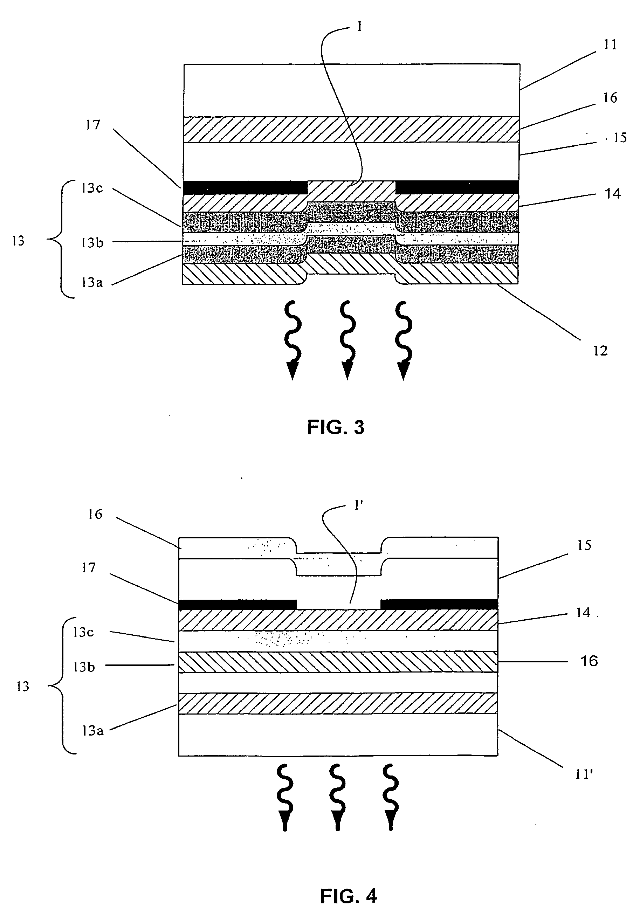

En se référant à la figure 3 qui concerne un premier mode de réalisation, les électrodes de la couche conductrice intermédiaire 14 sont transparentes et sont ici partiellement masquées par une couche opaque intermédiaire 17 dotée d'ouvertures de passage de la lumière, ici un trou 1 ; cette couche opaque intermédiaire 17 est comprise entre la couche conductrice intermédiaire 14 et la couche photoconductrice 15 ; chaque trou 1 de passage de la lumière est positionné approximativement au centre de la surface d'émission d'une cellule ; ces trous sont destinés au couplage optique entre la couche électroluminescente 13 et la couche photoconductrice 15; dans le mode de réalisation représenté ici, le substrat 11 est au dos du panneau.

La figure 4 représente un mode de réalisation identique à celui de la figure 3, à la différence près que le substrat 11' est sur la face avant du panneau ; ce panneau émet les images donc au travers du substrat.

De manière générale, en jouant sur le nombre de trous par cellule, sur la taille de ces trous ou ouvertures pratiqués dans la couche intermédiaire opaque 17, on peut très facilement adapter localement l'excitation de la couche photoconductrice 15 au niveau de chaque cellule du panneau, pour obtenir l'effet mémoire souhaité ; chaque groupe d'ouvertures propre à une cellule assure le couplage optique entre la zone de couche électroluminescente et la zone de couche photoconductrice propres à cette cellule ; le couplage optique généré par un groupe d'ouvertures propre à une cellule est fonction à la fois de la surface de ces ouvertures ou de la somme des surfaces des ouvertures d'un groupe, mais également de la disposition et de la forme de ces ouvertures ; les ouvertures de chaque groupe peuvent présenter n'importe quelle forme adaptée : par exemple circulaire, carrée, elliptique, rectangulaire, voire en forme de fente allongée.

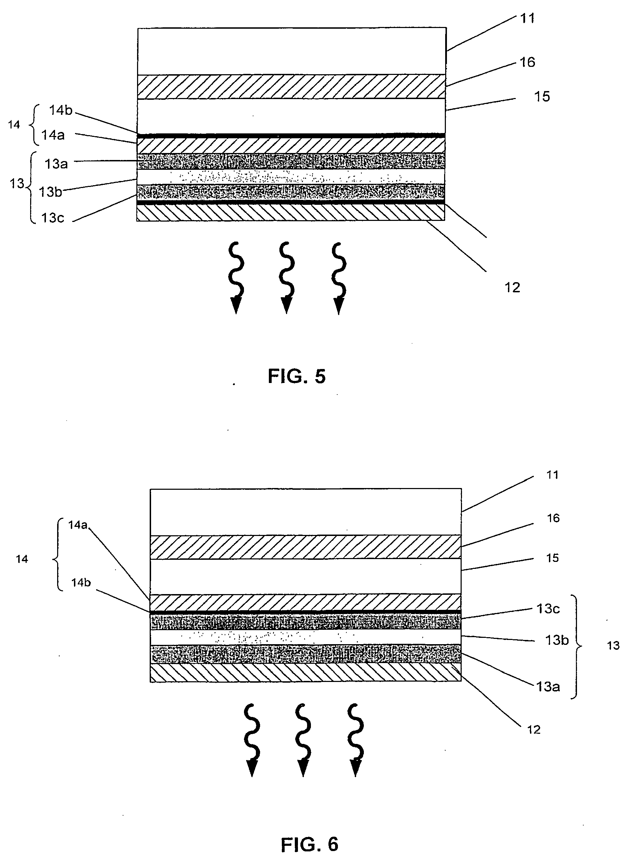

Selon un deuxième mode de réalisation représenté à la figure 6, la couche conductrice intermédiaire 14 d'électrodes est semi-transparente ; elle comprend une sous-couche conductrice transparente 14a d'ITO (« indium Tin Oxide » en langue anglaise) et une sous-couche semi-transparente à base d'aluminium 14b d'épaisseur adaptée à la densité optique souhaitée, généralement comprise entre 10 et 100 nm ; à l'interface entre cette sous-couche d'aluminium et sous-couche d'injection d'électrons 13c, on applique généralement une pellicule à base de fluorure de lithium d'épaisseur moyenne de l'ordre de 1 nm.

La figure 5 représente un mode de réalisation identique à celui de la figure 6, à la différence près que la structure de la couche électroluminescente est inversée; les électrodes de la couche avant 12 sont alors des cathodes et celles de la couche intermédiaire 14 sont des anodes ; pour un bon fonctionnement, la sous-couche d'ITO 14a est alors directement au contact de la sous-couche d'injection de trous 13a et la sous-couche semi-transparente 14b est reportée à l'interface avec la couche photoconductrice 15; aucune pellicule de fluorure de lithium n'est alors nécessaire.

De manière générale, en jouant sur la densité optique de la couche conductrice intermédiaire 14 semi-transparente, ici sur l'épaisseur de la couche d'aluminium, on peut très facilement adapter localement l'excitation de la couche photoconductrice 15 au niveau de chaque cellule du panneau, pour obtenir l'effet mémoire souhaité.

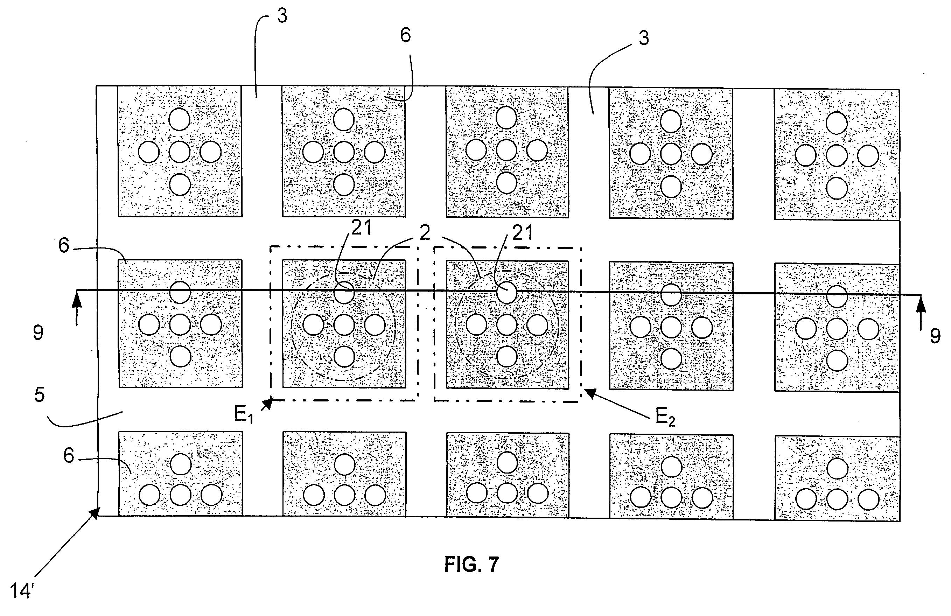

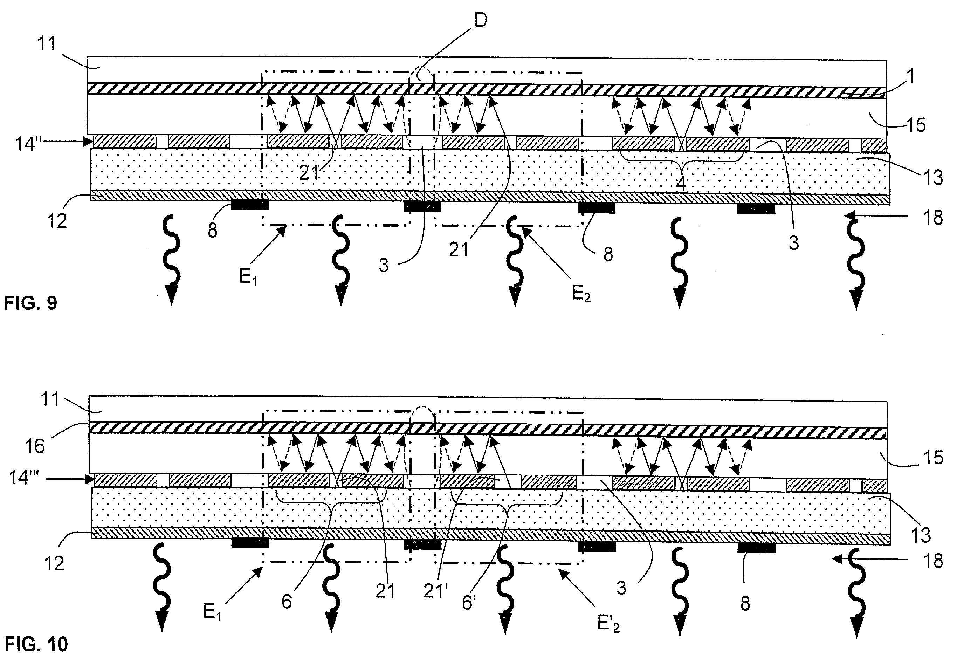

Selon un troisième mode de réalisation représenté aux figures 7 et 9, les électrodes de la couche intermédiaire 14' sont opaques et percées de plusieurs ouvertures de passage de la lumière au niveau de chaque cellule ; comme représenté sur la figure 7 en vue de face de la couche intermédiaire 14', cette couche intermédiaire comprend elle-même, au niveau de chaque cellule E₁, E₂ du panneau, un groupe 2 de cinq ouvertures de couplage optique traversant cette couche opaque, dont par exemple l'ouverture 21 par lequel passe le plan de coupe 9-9 correspondant à la figure 9 ; chaque groupe d'ouvertures propre à une cellule assure, comme dans le premier mode de réalisation, le couplage optique entre la zone de couche électroluminescente et la zone de couche photoconductrice propres à cette cellule.

Comme représenté à la figure 9, d'une manière classique, le panneau est ici en outre doté d'une couche d'amélioration du contraste 18 comprenant des bandes opaques 8 positionnées entre les cellules ; ces bandes opaques 8 peuvent être absorbantes (noires) ou réfléchissantes.

Lorsque la couche arrière opaque d'électrodes est réfléchissante, ce qui est généralement le cas, pour améliorer le contraste, il est avantageux d'utiliser des bandes réfléchissantes pour la couche d'amélioration du contraste 18 et d'ajouter, en face avant du panneau, un polariseur circulaire dont la fonction sera d'arrêter toutes les réflexions internes de lumière ambiante.

Comme illustré à la figure 9, les deux interfaces de la couche photoconductrice 15 sont ici réfléchissantes; ces deux interfaces correspondent ici à la surface de la couche arrière d'électrodes 16 et à la surface de la couche intermédiaire d'électrodes 14', toutes deux au contact de la couche photoconductrice 15.

Comme figuré par les flèches de la figure 9, ces interfaces réfléchissantes jouent alors le rôle de guide de lumière pour la lumière parvenant dans la couche photoconductrice 15 au travers des ouvertures 21 pratiquées dans la couche d'électrodes intermédiaires 14' ; comme l'illustre cette figure, cette lumière peut alors se propager de manière à illuminer et à exciter une grande surface de couche photoconductrice, ce qui diminue avantageusement la résistance électrique de cette couche à l'état excité et limite les pertes électriques.

Comme chaque cellule E₁, E₂ dispose de son électrode intermédiaire 6, que les différentes électrodes intermédiaires 6 sont isolées électriquement les unes des autres, la couche intermédiaire 14 présente des discontinuités qui forment des bandes parallèles horizontales 3 et verticales 5 de dépouilles dans la couche d'électrodes intermédiaires 14 dans des zones « inter-cellules ».

On aboutit ainsi à un panneau dont les cellules voisines E₁, E₂ sont optiquement isolées les unes des autres, de sorte que, au sein du guide de lumière constitué par la couche photoconductrice 15 et comme l'illustre l'absence de flèches de réflexion de lumière au niveau de la zone pointillée D de la figure 9, la lumière provenant d'une cellule E₁ ne parvient plus dans la cellule voisine E₂ ; on limite ainsi d'une manière très simple et économique les risques de couplage optique entre des cellules voisines du panneau.

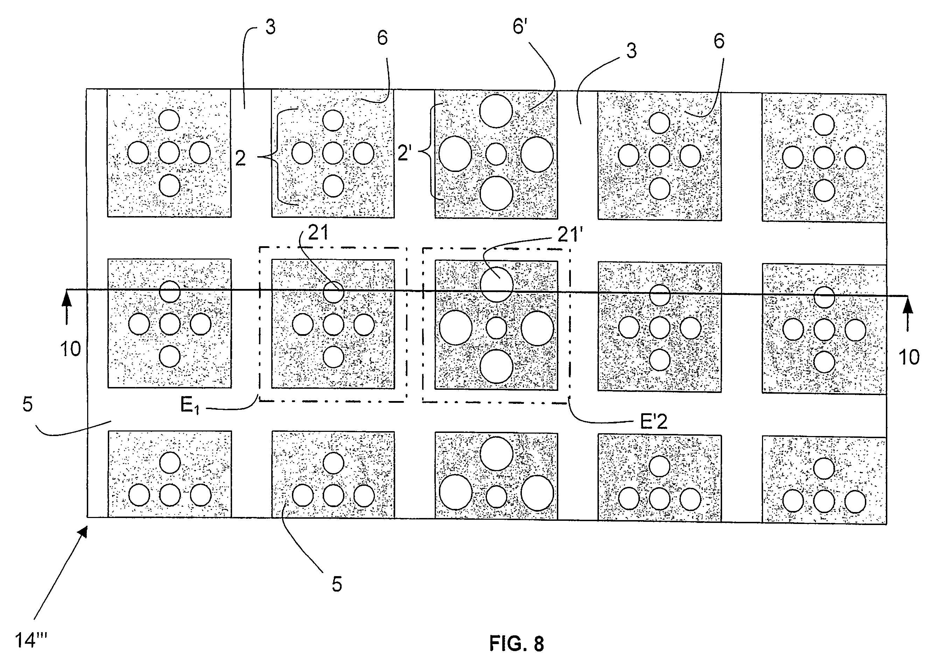

Selon un quatrième mode de réalisation représenté aux figures 8 et 10 qui concerne des panneaux de visualisation polychromatiques, la surface des ouvertures de couplage optiques 21, 21' est différente pour des cellules électroluminescentes E₁, E₂' qui émettent des couleurs différentes ; cette disposition permet d'adapter le couplage optique propre à chaque cellule à la couleur d'émission de cette cellule, il est alors facile d'obtenir une conductivité identique à l'état excité pour toutes les zones de couche photoconductrice 15 au regard de toutes les cellules du panneau, quelle que soit leur couleur d'émission, et d'améliorer ainsi le fonctionnement du panneau.

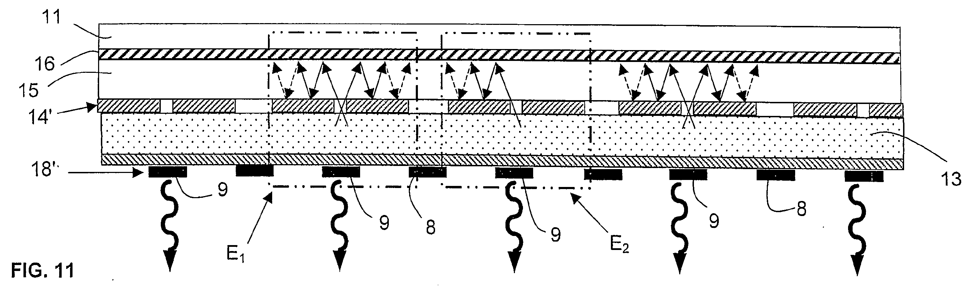

Selon un cinquième mode de réalisation de l'invention, en se référant à la figure 11, la couche de réseau noir d'amélioration du contraste 18 comprend, outre les bandes opaques 8 d'amélioration du contraste, des éléments opaques de masquage 9 disposés chacun en regard de chacune des ouvertures 21 des groupes d'ouvertures 2 de couplage optique ; grâce à ces éléments opaques de masquage 9, on limite les risques d'entrée de lumière ambiante dans la couche photoconductrice 15 et les risques de dysfonctionnements du panneau sous lumière ambiante qui en résultent.

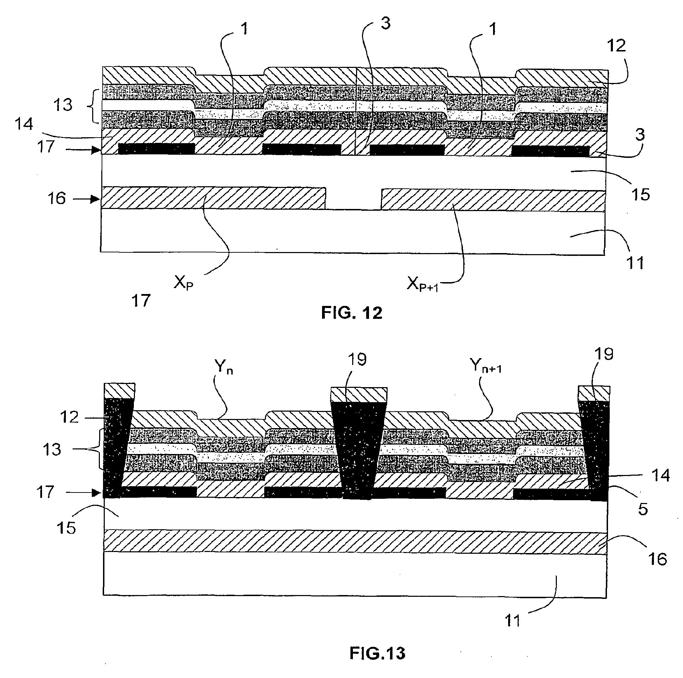

Pour fabriquer les panneaux électroluminescent de visualisation selon l'invention, on utilise des méthodes de dépôt et de gravure de couches classiques pour l'homme du métier de ce type de panneaux ; on va maintenant décrire un procédé de fabrication d'un tel panneau en référence aux figures 12 et 13 qui sont des coupes du panneau respectivement selon la direction des électrodes lignes et selon la direction des électrodes colonnes.

Sur un substrat 11 formé par exemple par une plaque de verre, on dépose une couche homogène d'aluminium par pulvérisation cathodique ou par évaporation sous vide (« PVD ») puis on grave la couche obtenue de manière à former un réseau d'électrodes parallèles ou électrodes de colonnes Xₚ, Xₚ₊₁ : on obtient ainsi la couche arrière opaque d'électrodes 16.

Sur cette couche d'électrodes 16, on dépose ensuite une couche homogène de matériau photoconducteur 15 : par exemple du silicium amorphe par dépôt chimique en phase vapeur assisté par plasma (« PECVD », ou Plasma Enhanced Chemical Vapor Deposition en langue anglaise), ou un matériau photoconducteur organique par dépôt chimique en phase vapeur (« CVD ») ou dépôt par centrifugation (« spin-coating » en langue anglaise).

Pour fabriquer un panneau selon le premier mode de réalisation décrit ci-dessus, on applique ensuite la couche opaque intermédiaire 17 : dépôt d'une couche homogène d'aluminium comme précédemment, puis gravure :
- des ouvertures de couplage optique 1 à pratiquer dans cette couche, groupées par pixels, chaque groupe d'ouvertures étant centré sur la surface émissive d'un pixel,
- des zones inter-cellules 3, 5 pour isoler électriquement, selon l'invention, les électrodes intermédiaires des cellules voisines et pour isoler optiquement les cellules du panneau les unes des autres ;

On applique ensuite par pulvérisation cathodique sous vide une couche mince d'oxyde mixte d'étain et d'indium (« ITO ») d'épaisseur homogène ; l'épaisseur et les conditions de dépôts sont adaptées d'une manière connue en elle-même pour obtenir une couche qui présente une conductivité dans le sens parallèle aux plans des interfaces entre les couches beaucoup plus faible que dans le sens transverse de l'épaisseur ; alors que la couche est d'épaisseur homogène, on parvient ainsi à isoler électriquement, selon l'invention, les électrodes intermédiaires des cellules voisines, ce qui permet d'utiliser le procédé de pilotage du panneau décrit ci-après ; la couche obtenue correspond à la couche intermédiaire d'électrodes 14.

On forme ensuite un réseau de barrières 19 destinées à partitionner le panneau en lignes de cellules électroluminescentes : à cet effet, on dépose d'abord une couche homogène de résine organique de barrière par centrifugation (« spin-coating » en langue anglaise), puis on grave cette couche de manière à former le réseau de barrières 19 en résine perpendiculairement aux électrodes de colonnes ; l'épaisseur de cette couche ou la hauteur des barrières est largement supérieure à l'épaisseur des couches encore à déposer, comme représenté sur la figure 13.

On dépose ensuite entre les barrières 19 les couches organiques destinées à former des lignes de cellules électroluminescentes : on obtient ainsi la couche organique électroluminescente 13.

On dépose ensuite, toujours entre les barrières, la couche conductrice transparente 12 de manière à former des lignes d'électrodes Yₙ, Yₙ₊₁ : de préférence, cette couche comprend la cathode et une couche d'ITO.

On obtient ainsi un panneau de visualisation d'images selon l'invention.

## Revendications

1. Panneau de visualisation d'images formé d'une matrice de cellules électroluminescentes (E₁, E₂) à effet mémoire, susceptibles d'émettre de la lumière vers l'avant dudit panneau, comprenant :
- une couche électroluminescente (13),
- à l'avant de cette couche, une couche avant transparente d'électrodes (12),
- à l'arrière de cette couche, une couche photoconductrice (15) pour obtenir ledit effet mémoire, elle-même intercalée entre une couche arrière opaque d'électrodes (16) et une couche transparente ou semi-transparente intermédiaire (14) d'électrodes intermédiaires (6) au contact de la couche électroluminescente (13), où chaque cellule (E₁, E₂) est dotée d'une électrode intermédiaire (6) et où les électrodes intermédiaires des différentes cellules sont isolées électriquement les unes des autres,et où, en outre,
**soit** ledit panneau comprend également une couche opaque comprise entre ladite couche électroluminescente (13) et ladite couche photoconductrice (15) qui comprend elle-même, au niveau de chaque cellule (E₁, E₂) du panneau, un groupe (2) d'au moins une ouverture (1, 21) de couplage optique traversant ladite couche opaque, ledit panneau étant alors **caractérisé en ce que** ladite couche électroluminescente (13) est organique, **en ce que** ledit panneau comprend également au moins deux groupes de cellules électroluminescentes (E₁, E'₂) susceptibles d'émettre de la lumière de couleur différente et **en ce que** la densité d'ouvertures et/ou la somme des surfaces des ouvertures (21, 21') d'un groupe (2, 2') d'ouvertures diffère(nt) selon lesdits groupes de cellules (E₁, E'₂) de couleur différente,
**soit** ledit panneau est **caractérisé en ce que** ladite couche électroluminescente (13) est organique, en que ladite couche intermédiaire d'électrodes est semi-transparente et présente une densité optique adaptée au couplage optique nécessaire entre ladite couche électroluminescente (13) et ladite couche photoconductrice (15) pour obtenir ledit effet mémoire, **en ce que** ledit panneau comprend au moins deux groupes de cellules électroluminescentes (E₁, E'₂) susceptibles d'émettre de la lumière de couleur différente et **en ce que** la densité optique de ladite couche intermédiaire d'électrodes diffère selon lesdits groupes de cellules (E₁, E'₂) de couleur différente.

2. Panneau selon la revendication 1 **caractérisé en ce que**, dans le cas où ledit panneau comprend une couche opaque comprise entre ladite couche électroluminescente (13) et ladite couche photoconductrice (15), chaque groupe (2) d'au moins une ouverture (1, 21) est positionné approximativement au centre d'une cellule (E₁, E₂).

3. Panneau selon l'une quelconque des revendications 1 à 2 **caractérisé en ce que**, dans le cas où ledit panneau comprend une couche opaque comprise entre ladite couche électroluminescente (13) et ladite couche photoconductrice (15), ladite couche opaque fait partie de ladite couche intermédiaire d'électrodes (14).

4. Panneau selon l'une quelconque des revendications 1 à 3 **caractérisé en ce que**, dans le cas où ledit panneau comprend une couche opaque comprise entre ladite couche électroluminescente (13) et ladite couche photoconductrice (15), il comprend aussi, en regard de chaque ouverture (21) de chaque groupe (2) d'ouvertures de couplage optique, un élément opaque de masquage (9) positionné à l'avant de ladite couche électroluminescente (13).

5. Panneau selon l'une quelconque des revendications 1 à 4 **caractérisé en ce que** les deux interfaces de la couche photoconductrice sont réfléchissantes.

6. Procédé de commande d'un panneau selon l'une quelconque des revendications 1 à 5 **caractérisé en ce que**, chaque cellule (E_{n,p}) du panneau étant alimentée entre une électrode d'adressage et de maintien (Yₙ) de ladite couche avant ou arrière et une électrode dite de donnée (Xₚ) de l'autre couche, arrière ou avant, il comprend les étapes dans lesquelles :
- on applique successivement à chaque électrode d'adressage et de maintien (Yₙ), un signal dit de déclenchement d'écriture Vₐ lors d'une phase d'adressage et on applique pendant ce temps aux autres électrodes d'adressage et de maintien un signal dit de maintien V_{S},
- et, pendant l'application d'un signal d'écriture Vₐ à ladite électrode d'adressage et de maintien (Yₙ), on applique simultanément aux électrodes de donnée (X₁, ..., Xₚ, ...) un signal de donnée de valeur soit V_{Off}, soit V_{On} selon que l'on souhaite respectivement ne pas activer ou activer la cellule située au croisement de l'électrode de donnée considérée avec ladite électrode d'adressage et de maintien lors de la phase subséquente de maintien des cellules alimentées par ladite électrode d'adressage et de maintien (Yₙ).

7. Procédé de commande selon la revendication 6 **caractérisé en ce que**, si V_{T} est la tension aux bornes d'une cellule du panneau au delà de laquelle une cellule éteinte à l'état non activé « OFF » passe à l'état activé « ON », si V_{D} est la tension de déclenchement de l'émission de la portion de ladite couche électroluminescente correspondant à une cellule, on a :
- Vₐ-Vₒₙ ≥ V_{T} et Vₐ-V_{off} < V_{T}
- V_{S}-Vₒₙ < V_{T} et Vₛ-V_{off} > V_{D}

8. Procédé de commande selon l'une quelconque des revendications 6 ou 7 **caractérisé en ce qu'**il comprend en outre une étape dans laquelle on applique simultanément, lors de chaque phase d'adressage d'une électrode d'adressage et de maintien (Yₙ), un signal V_{C} dit de compensation aux différentes électrodes de donnée (X₁, ..., Xₚ, ...), où V_{C}= V_{Off} pour les électrodes de données recevant un signal de donnée Vₒₙ lors de ladite phase d'adressage, où V_{C}= Vₒₙ pour les électrodes de données recevant un signal de donnée V_{off} lors de ladite phase d'adressage, la durée d'application dudit signal de compensation V_{C} étant approximativement égale à la durée d'application du signal de donnée Vₒₙ ou V_{off}.

## Patentansprüche

1. Bildanzeigeschirm, gebildet durch eine Matrix aus elektrolumineszenten (E₁, E₂) mit Speichereffekt, welche Licht zum vorderen Teil des Bildschirms aussenden können, umfassend:
- eine elektrolumineszente Schicht (13),
- im vorderen Teil dieser Schicht eine transparente Vorderschicht aus Elektroden (12),
- im hinteren Teil dieser Schicht eine photoleitende Schicht (15) zur Erzielung des Speichereffekts, welche wiederum zwischen einer lichtundurchlässigen Hinterschicht aus Elektroden (16) und einer transparenten oder halttransparenten Zwischensicht (14) aus Zwischenelektroden (6) in Kontakt mit der elektrolumineszenten Schicht (13) angeordnet ist, wobei jede Zelle (E₁, E₂) mit einer Zwischenelektrode (6) versehen ist und wobei die Zwischenelektroden der unterschiedlichen Zellen elektrisch gegeneinander isoliert sind und wobei ferner
**entweder** der Bildschirm ebenfalls eine lichtundurchlässige Schicht zwischen der elektrolumineszenten Schicht (13) und der photoleitenden Schicht (15) umfasst, die wiederum an jeder Zelle (E₁, E₂) des Bildschirms eine Gruppe (2) mit mindestens einer Öffnung (1, 21) für die optische Kopplung durch die lichtundurchlässige Schicht umfasst, wobei der Bildschirm dann **dadurch gekennzeichnet ist, dass** die elektrolumineszente Schicht (13) organisch ist, dass der Bildschirm ebenfalls mindestens zwei Gruppen elektrolumineszenter Zellen (E₁, E'₂) umfasst, die Licht mit unterschiedlicher Farbe aussenden können, und dass die Dichte der Öffnungen und/der die Summe der Flächen der Öffnungen (21, 21') einer Gruppe (2, 2') von Öffnungen je nach den Gruppen von Zellen (E₁, E'₂) unterschiedlicher Farbe unterschiedlich sind,
**oder** der Bildschirm **dadurch gekennzeichnet ist, dass** die elektrolumineszente Schicht (13) organisch ist, die Elektrodenzwischenschicht halbtransparent ist und eine optische Dichte aufweist, die für die optische Kopplung geeignet ist, welche zwischen der elektrolumineszenten Schicht (13) und der photoleitenden Schicht (15) erforderlich ist, um den Speichereffektz zu erzielen, dass der Bildschirm mindestens zwei Gruppen elektrolumineszenter Zellen (E₁, E'₂) umfasst, die Licht mit unterschiedlicher Farbe aussenden können, und dass die optische Dichte der Elektrodenzwischenschicht je nach den Gruppen von Zellen (E₁, E'₂) unterschiedlicher Farbe unterschiedlich ist.

2. Bildschirm nach Anspruch 1 **dadurch gekennzeichnet, dass**, wenn der Bildschirm eine lichtundurchlässige Schicht zwischen der elektrolumineszenten Schicht (13) und der photoleitenden Schicht (15) umfasst, jede Gruppe (2) mit mindestens einer Öffnung (1, 21) annähernd in der Mitte einer Zelle (E₁, E₂) angeordnet ist.

3. Bildschirm nach einem beliebigen der Ansprüche 1 bis 2, **dadurch gekennzeichnet, dass**, wenn der Bildschirm eine lichtundurchlässige Schicht zwischen der elektrolumineszenten Schicht (13) und der photoleitenden Schicht (15) umfasst, die lichtundurchlässige Schicht Bestandteil der Elektrodenzwischenschicht (14) ist.

4. Bildschirm nach einem beliebigen der Ansprüche 1 bis 3, **dadurch gekennzeichnet, dass**, wenn der Bildschirm eine lichtundurchlässige Schicht zwischen der elektrolumineszenten Schicht (13) und der photoleitenden Schicht (15) umfasst, er ferner gegenüber jeder Öffnung (21) jeder Gruppe (2) von Öffnungen für optische Kopplung ein lichtundurchlässiges Abdeckelement (9) umfasst, das im vorderen Teil der elektrolumineszenten Schicht (13) angeordnet ist.

5. Bildschirm nach einem beliebigen der Ansprüche 1 à 4, **dadurch gekennzeichnet, dass** die zwei Schnittstellen der photoleitenden Schicht reflektierend sind.

6. Verfahren zur Steuerung eines Bildschirms nach einem beliebigen der Ansprüche 1 bis 5, **dadurch gekennzeichnet, dass**, wenn jede Zelle (E_{n,p}) des Bildschirms zwischen einer Adressier- und Sustain-Elektrode (Yₙ) der Vorder-oder Hinterschicht und einer sogenannten Datenelektrode (Xₚ) der anderen Vorder- oder Hinterschicht beaufschlagt wird, es die folgenden Schritte aufweist:
- es wird sukzessive an jede Adressier- und Sustainelektrode (Yₙ) ein so genanntes Schreibauslösesignal Vₐ während einer Adressierphase angelegt und es wird in dieser Zeit an die anderen Adressier- und Sustain-Elektroden ein sogenanntes Erhaltungssignal V_{S} angelegt, und
- während des Anlegens eines Schreibsignals Vₐ an die Adressier- und Sustainelektrode (Yₙ) gleichzeitig ein Wertdatensignal V_{Off} oder V_{On} an die Datenelektroden (X₁, ..., Xₚ, ...) angelegt wird, je nachdem, ob die Zelle an der Kreuzung zwischen der betreffenden Datenelektrode und der Adressier- und Sustainelektrode während der nachfolgenden Phase der Erhaltung der Zellen nicht aktiviert bzw. aktiviert werden soll, welche von der Adressier- und Sustainelektrode (Yₙ) beaufschlagt werden.

7. Steuerungsverfahren nach Anspruch 6, **dadurch gekennzeichnet, dass**, wenn V_{T} die Spannung an den Klemmen einer Zelle des Bildschirms ist, über welche hinaus eine ausgeschaltete Zelle vom nicht aktivierten Zustand "OFF" in den aktivierten Zustand "ON" übergeht, wenn V_{D} die Spannung zum Auslösen der Aussendung durch den einer Zelle entsprechenden Abschnitt der elektrolumineszenten Schicht ist, dann:
- Vₐ-Vₒₙ ≥ V_{T} und Vₐ-V_{off} < V_{T}
- V_{S}-Vₒₙ < V_{T} und Vₛ-V_{off} > V_{D}

8. Steuerungsverfahren nach einem beliebigen der Ansprüche 6 oder 7, **dadurch gekennzeichnet, dass** es ferner einen Schritt umfasst, bei dem bei jeder Adressierphase einer Adressier- und Sustainelektrode (Yₙ) ein so genanntes Kompensationssignal V_{C} gleichzeitig an die unterschiedlichen Datenelektroden (X₁, ..., Xₚ, ...) angelegt wird, wobei V_{C}= V_{Off} für die Datenelektroden, die ein Datensignal Vₒₙ während der Adressierphase erhalten, wobei V_{C}= Vₒₙ für die Datenelektroden, die ein Datensignal V_{off} während der Adressierphase erhalten, wobei die Dauer des Anlegens des Kompensationssignals V_{C} annähernd der Dauer des Anlegens des Datensignals Vₒₙ oder V_{off} entspricht.

## Claims

1. Image display panel comprising a memory effect electroluminescent cell matrix (E₁, E₂) capable to transmit light to the front of said panel, comprising:
- an electroluminescent layer (13),
- to the front of this layer, a transparent front layer of electrodes (12),
- to the back of this layer, a photoconducting layer (15) for obtaining produce said memory effect, inserted between an opaque back layer of electrodes (16) and a transparent or semi-transparent intermediary layer (14) of intermediary electrodes (6) in contact with the electroluminescent layer (13), where each cell (E₁, E₂) includes an intermediary electrode (6) and where the intermediary electrodes from the various cells are electrically isolated from one another, and where, also,
**either** said panel also comprises an opaque layer between said electroluminescent layer (13) and said photoconducting layer (15), which comprises for each panel cell (E₁, E₂) a group (2) of at least one optical coupling opening (1, 21) passing through said opaque layer, said panel then being **characterised in that** said electroluminescent layer (13) is organic, **in that** said panel also comprises at least two groups of electroluminescent cells (E₁, E'₂) capable to transmit light of a different colour, and **in that** the opening density and/or the sum of the surfaces of the openings (21, 21') of a group (2, 2') of openings differs, according to said differently coloured groups of cells (E₁, E'₂),
**or** said panel is **characterised in that** said electroluminescent layer (13) is organic, **in that** said intermediary layer of electrodes is semi-transparent and has suitable optical density for the optical coupling necessary between said electroluminescent layer (13) and said photoconducting layer (15) to obtain said memory effect, **in that** said panel comprises at least two groups of electroluminescent cells (E₁, E'₂) capable to transmit light of a different colour, and **in that** the optical density of said intermediary layer of electrodes differs according to said differently-coloured groups of cells (E₁, E'₂).

2. Panel according to claim 1 **characterised in that**, where said panel comprises an opaque layer between said electroluminescent layer (13) and said photoconducting layer (15), each group (2) of at least one opening (1, 21) is positioned approximately in the centre of a cell (E₁, E₂).

3. Panel according to any one of claims 1 to 2 **characterised in that**, where said panel comprises an opaque layer between said electroluminescent layer (13) and said photoconducting layer (15), said opaque layer is part of said intermediary layer of electrodes (14).

4. Panel according to any one of claims 1 to 3 **characterised in that**, where said panel comprises an opaque layer between said electroluminescent layer (13) and said photoconducting layer (15), it also comprises, with regard to each opening (21) of each group (2) of optical coupling openings, an opaque masking element (9) positioned to the front of said electroluminescent layer (13).

5. Panel according to any one of claims 1 to 4 **characterised in that** the two interfaces of the photo-conducting layer are reflective.

6. Panel command process according to any one of claims 1 to 5 **characterised in that**, each panel cell (E_{n,p}) being powered between an addressing and sustain electrode (Yₙ) of said front and back layer and a data electrode (Xₚ) of the other layer, back or front, it comprises the following steps wherein:
- a so-called write trigger signal Vₐ will be applied successively to each addressing and sustain electrode (Yₙ), during an addressing phase while a so-called hold signal V_{S} is applied to the other addressing and sustain electrodes,
- and, during the application of a write signal Vₐ to said addressing and sustain electrode (Yₙ), a data signal having a value of V_{Off} or V_{On} is simultaneously applied to the data electrodes (X₁, ..., Xₚ, ...), depending on whether the cell at the intersection of the data electrode considered is to be activated or not activated with said addressing and sustain electrode during the subsequent sustain phase of the cells powered by said addressing and sustain electrode (Yₙ).

7. Command process according to claim 6 **characterised in that**, if V_{T} is the voltage at the terminals of a panel cell beyond which a cell switched to the inactive state "OFF" changes to the active state "ON", if V_{D} is the voltage that triggers the transmission of the portion of said electroluminescent layer corresponding to a cell, we have:
- Vₐ-Vₒₙ ≥ V_{T} and Vₐ-V_{off} < V_{T}
- V_{S}-Vₒₙ < V_{T} and Vₛ-V_{off} > V_{D}

8. Command process according to any one of claims 6 or 7 **characterised in that** it also comprises a step wherein a so-called compensation signal V_{C} is simultaneously applied to the data electrodes (X₁, ..., Xₚ, ...), during each addressing phase of an addressing and sustain electrode (Yₙ), where V_{C}= V_{Off} for the data electrodes receiving a data signal Vₒₙ during said addressing phase, where V_{C}= Vₒₙ for the data electrodes receiving a data signal V_{off} during said addressing phase, the period of application of said compensation signal V_{C} being approximately equal to the period of application of the data signal Vₒₙ or V_{off}.
